# EUROPEAN PATENT SPECIFICATION

(11) **EP 2 398 043 B1**
(45) Date of publication and mention of the grant of the patent: **28.12.2016**
(21) Application number: 10741038.3
(22) Date of filing: 28.01.2010
(51) Int. Cl.: H01L 21/205, H05H 1/46, C23C 16/507, C23C 16/455, H01J 37/32

(54) **THIN FILM FORMING APPARATUS AND THIN FILM FORMING METHOD**
VORRICHTUNG FÜR DÜNNSCHICHTBILDUNG UND VERFAHREN FÜR DÜNNSCHICHTBILDUNG
APPAREIL DE FORMATION DE COUCHE MINCE ET PROCÉDÉ DE FORMATION DE COUCHE MINCE

(30) Priority: 13.02.2009 JP 2009032041
(43) Date of publication of application: 21.12.2011
(73) Proprietor: Mitsui Engineering & Shipbuilding Co., Ltd., Chuo-ku Tokyo 104-8439 (JP)
(72) Inventor: TAKIZAWA, Kazuki, Tamano-shi, Okayama 706-8651 (JP); MORI, Yasunari, Tamano-shi, Okayama 706-8651 (JP); MURATA, Kazutoshi, Tamano-shi, Okayama 706-8651 (JP)
(74) Representative: Global IP Europe Patentanwaltskanzlei
(86) International application number: PCT/JP2010/000483
(87) International publication number: WO 2010/092758

(56) References cited:
- JP-A- 57 097 617
- JP-A- 2001 351 908
- JP-A- 2004 356 651
- US-A- 5 619 103

## Description

### TECHNICAL FIELD

The present invention relates to a thin film forming apparatus and a thin film forming method for forming a thin film on a substrate using plasma.

### BACKGROUND ART

Recently, an atomic layer growing method (hereinafter also abbreviated to an ALD (Atomic Layer Deposition) method) for forming a thin film on a substrate in units of atomic layers has attracted attention as a thin film forming method. In the ALD, two types of gases that mainly contain elements constituting a film to be deposited are alternately supplied onto the deposition target substrate, and the thin film is formed on the substrate in units of atomic layers. A film having a desired thickness is formed by repeatedly forming the thin film in units of atomic layers. For example, a source gas containing TMA (Tri-Methyl Aluminum) and the oxidizing gas containing O are used when an Al₂O₃ film is formed on the substrate. The nitriding gas is used instead of the oxidizing gas when a nitride film is formed on the substrate.

A so-called self-stopping action (self-limit function) of growth is utilized in the ALD method. That is, in the self-stopping action of growth, only one or several layers of source gas components is adsorbed on a substrate surface during supply of the source gas, and the excess source gas does not contribute to the growth of the thin film.

The thin film formed by the ALD method has both a high step coverage characteristic and a high film-thickness control characteristic compared with the thin film formed by a general CVD (Chemical Vapor Deposition) method. Therefore, the ALD method is expected to become commonplace in forming a capacitor of a memory element and an insulating film called a "high-k grate". Because the insulating film can be formed at a low temperature of about 300°C, the ALD method is also expected to be applied to formation of a gate insulating film of a thin film transistor in a display device, such as a liquid crystal display, in which a glass substrate is used.

In the ALD method, when the source gas component adsorbed on the substrate is oxidized, the plasma is generated using the oxidizing gas. At this point, an oxygen radical is produced by the plasma, and the source gas component adsorbed on the substrate is oxidized using the oxygen radical.

For example, in Patent Document 1, the thin film is formed on a surface of a treated body in an evacuated vessel by a heat treatment using a transition-metal-containing source gas and an oxygen-containing gas. The ALD method in which deposition is performed by repeatedly alternately supplying the source gas and the oxygen-containing gas is used as the heat treatment used to form the thin film. Therefore, in Patent Document 1, it is described that, for example, when a Mn-containing film or a CuMn-containing film is formed by the heat treatment such as CVD, a micro recess can be buried with high step coverage by the Mn-containing film or the CuMn-containing film.

USP 5,619,103 discloses a processing chamber having an internal space 212 and another internal space 90. These two spaces 212, 90 could have different pressure.

### PRIOR ART DOCUMENT

### Patent Document

Patent Document 1: Japanese Patent Application Laid-Open No. 2009-016782

In the ALD method disclosed in Patent Document 1, the micro recess can be buried with the high step coverage by the thin film. However, unfortunately it takes a long time to form the thin film and production efficiency is degraded. Additionally, because the inside of the treatment vessel gets dirty when the thin film is formed by the plasma, it is necessary to frequently clean the inside of the treatment vessel, which results in a problem in that considerable work and time for maintenance of the treatment vessel are required.

### SUMMARY OF INVENTION

### TECHNICAL PROBLEM

In order to solve the problems, an object of the invention is to provide a thin film forming apparatus and a thin film forming method for being able to enhance plasma generation density to efficiently form the thin film when the thin film is formed on the substrate using the plasma.

### SOLUTION TO PROBLEM

according to the appended claim 1 According to an aspect of the invention, a thin film forming apparatus according to the appended claim 1. is provided. Advantageous embodiments are defined in the appended dependent claims. The thin film forming apparatus include:
an outside vacuum vessel that constitutes a first internal space;
an inside vacuum vessel that is provided in the first internal space of the outside vacuum vessel to constitute a second internal space;
a plasma source that is provided in the first internal space, the plasma source receiving supply of a high-frequency power to generate the plasma; and
a substrate stage that is provided opposite the plasma source in the first internal space, the second internal space being surrounded by the substrate stage and the inside vacuum vessel, the substrate being placed on the substrate stage in the second internal space.

The substrate placed on the substrate stage is disposed in the second internal space, and

pressures of the first internal space and the second internal space and a power supplied to the plasma source are controlled such that the plasma is generated in the second internal space while not generated in the first internal space.

According to another aspect of the invention, a thin film forming method for forming a thin film on a substrate using plasma is provided. The thin film forming method includes the steps of:
controlling pressures of a first internal space and a second internal space provided in the first internal space according to determined pressure conditions;
causing a source gas to flow onto the substrate in the second internal space and supplying a high-frequency power to a plasma source provided in the first internal space according to the pressure conditions, thereby generating the plasma in the second internal space to form the thin film on the substrate.

### ADVANTAGEOUS EFFECTS OF INVENTION

In the thin film forming apparatus and the thin film forming method of the invention, the plasma generation density can be enhanced to efficiently form the thin film when the thin film is formed on the substrate using the plasma.

### BRIEF DESCRIPTION OF DRAWINGS

FIG. 1 is a schematic diagram illustrating a configuration of an ALD apparatus that is a thin film forming apparatus according to an embodiment of the invention.
FIG. 2 is a view for explaining an antenna array and a feed unit in the ALD apparatus of FIG. 1.
FIG. 3 is a view illustrating the ALD apparatus when a bell jar can be taken out while a substrate stage of the ALD apparatus of FIG. 1 is located in a lowering position.
FIG. 4 is a graph illustrating a relationship between a vacuum (pressure) and a power supplied to a plasma source in generating plasma.

### DESCRIPTION OF EMBODIMENTS

Hereinafter, a thin film forming apparatus and a thin film forming method according to an embodiment of the invention will be described in detail.

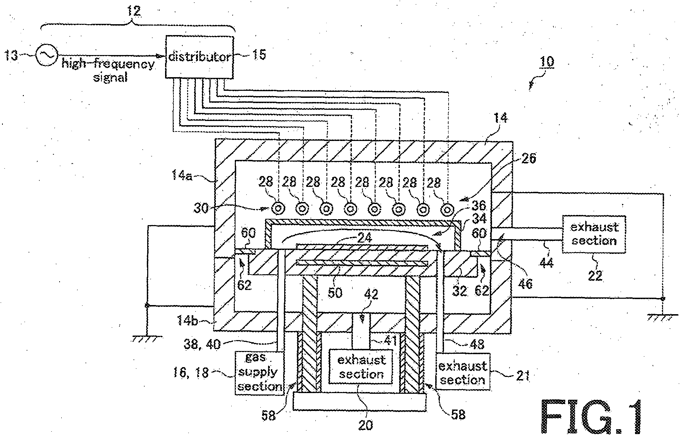

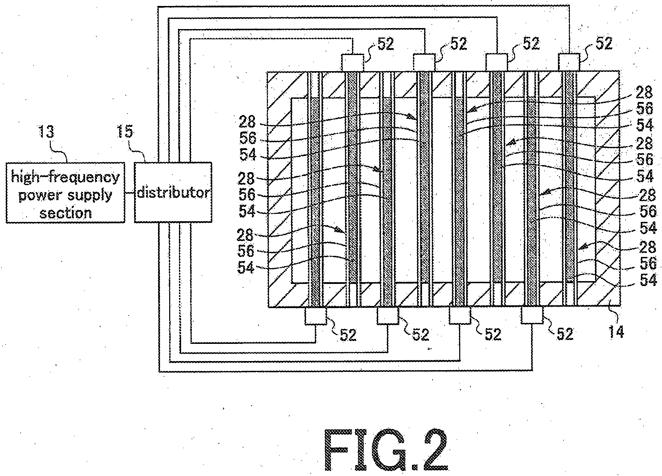

FIG. 1 is a schematic diagram illustrating a configuration of an ALD apparatus that is a film forming apparatus according to an embodiment of the invention. FIG. 2 is a view for explaining an antenna array and a feed unit in the ALD apparatus of FIG. 1.

FIG. 1 is the schematic diagram illustrating the configuration of the ALD apparatus of the embodiment to which a plasma generating device is applied. FIG. 2 is a view for explaining the antenna array and the feed unit in the ALD apparatus of FIG. 1.

An ALD apparatus 10 illustrated in FIG. 1 alternately supplies two types of deposition gases (source gas and oxidizing gas) onto a substrate 42 that is a deposition target. The two types of the gases mainly contain elements constituting a film to be formed by the ALD method. Then, the plasma is generated in order to enhance reaction activity, and an oxide film of the source gas is formed on the substrate in units of atomic layers. The above-described process is repeated plural cycles to form the thin film having a desired thickness. A nitriding gas may be used instead of the oxidizing gas.

The ALD apparatus 10 includes a feed unit 12, a deposition vessel (outside vacuum vessel) 14, gas supply sections 16 and 18 and exhaust sections 20, 21, and 22 provided with vacuum pumps. The case in which an oxide film is formed on the substrate 24 will be described by way of example. The same holds true for a nitride film. The gas supply sections 16 and 18 are disposed in a direction perpendicular to the paper plane of FIG. 1 so as to be in parallel each other, and the gas supply sections 16 and 18 are illustrated while overlapped with each other in FIG. 1. The deposition vessel 14 constitutes a first internal space 26. An antenna array 30 including plural antenna elements 28 and a substrate stage 32 are provided in the first internal space 26. In the first internal space 26, a bell jar (inside vacuum vessel) 34 is provided on the substrate stage 32 while fixed to the substrate stage 32. A second internal space 36 is formed while surrounded by the substrate stage 32 and the bell jar 34, and the second internal space 36 is separated from the first internal space 26. A mechanism (not illustrated) that is detachably attached to the substrate stage 32 is provided in the bell jar 34.

The feed unit 12 supplies a power (high-frequency signal) to each antenna element 28 of an antenna array 30 provided in the deposition vessel 14. The feed unit 12 includes a high-frequency signal generator 13 and a distributor 15, and the high-frequency signal generator 13 includes an oscillator and an amplifier.

The distributor 15 divides the high-frequency signal generated by the high-frequency signal generator 13 into plural high-frequency signals and supplies the high-frequency signals to the antenna elements 28. Lengths of feed lines from the distributor 15 to the antenna elements 26 are equal to one another.

The feed unit 12 feeds the power to each antenna element 28 of the antenna array 30 according to pressures (pressure conditions) that are set to the first internal space 26 and the second internal space 36.

The gas supply section 16 is connected to the second internal space 36 through a supply pipe 38 and a gas supply port provided in the substrate stage 32. The gas supply section 18 is also connected to the second internal space 36 through a supply pipe 40 and another gas supply port provided in the substrate stage 32. The gas supply section 16 supplies a source gas such as TMA (Tri-Methyl Aluminum) to the second internal space 36, and the gas supply section 18 supplies a source gas such as an oxidizing gas to the second internal space 36. The source gases are alternately supplied.

On the other hand, the exhaust section 20 is connected to an exhaust hole 42, which is provided while facing the first internal space 26 of the deposition vessel 14, through an exhaust pipe 41. Similarly to the exhaust section 20, the exhaust section 22 is connected to an exhaust hole 44, which is provided while facing the first internal space 26 of the deposition vessel 14, through an exhaust pipe 44. Each of the exhaust sections 20 and 22 includes a turbo-molecular pump that adjusts a vacuum (pressure) of the first internal space 26. The turbo-molecular pump controls the vacuum of the first internal space 26 in a range of 1 × 10⁻³ to 1 × 10⁻² Pa or a range of 1200 to 3000 Pa. The exhaust section 20 vertically evacuates a space below the first internal space 26 through the exhaust hole 42 and the exhaust pipe 41.

The exhaust section 21 includes a dry pump. The dry pump adjusts the vacuum (pressure) of the second internal space 36 while exhausting the source gas such as TMA and the oxidizing gas from the second internal space 36 through an exhaust pipe 48 and a gas exhaust port provided in the substrate stage 32. The dry pump controls the vacuum of the second internal space 36 in a range of 20 to 100 Pa. The reason the vacuum of the first internal space 26 is set higher than that of the second internal space 36 (the pressure of the first internal space 26 is set lower than that of the second internal space 36) or lower than that of the second internal space 36 (the pressure of the first internal space 26 is set higher than that of the second internal space 36) is that the plasma is not generated in the first internal space 26 by increasing or decreasing the vacuum of the first internal space 26. The plasma generation depends on the vacuum. The power necessary to generate the plasma is determined according to the supplied gas, and the plasma is hardly generated when the vacuum is higher or lower than a certain range, that is, there is the vacuum in which the plasma is easily generated. In the embodiment, the vacuum of the second internal space 36 is determined within the vacuum range in which the plasma is easily generated, and the vacuum of the first internal space 26 is determined to be higher or lower than the above-described vacuum range. The feed unit 12 feeds the power corresponding to the determined pressure to the antenna element 28. The reason the vacuum of the first internal space 26 is increased or decreased is that difficulty of the plasma generation can rapidly be increased by the increase or decrease of the vacuum to easily control the plasma generation.

Although not illustrated, on-off valves (for example, electromagnetic valves) that control communication between the gas supply sections 16 and 18 and the second internal space 36 are provided in the middles of the supply pipes 38 and 40, respectively. Although not illustrated, an on-off valve that controls communication between the exhaust section 21 and the second internal space 36 is provided in the middles of the exhaust pipe 48, and on-off valves (for example, electromagnetic valves) that control communication between the first internal space 26 and the exhaust sections 20 and 22 are provided in the middles of the exhaust pipes 41 and 44, respectively.

When the source gases are supplied from the gas supply sections 16 and 18 into the second internal space 36, the on-off valves of the supply pipes 38 and 40 are opened to supply the source gases into the second internal space 36. When the gas supplied into the second internal space 36 is exhausted, the on-off valve of the exhaust pipe 48 is opened. When the pressure in the first internal space 26 is adjusted, the on-off valves of the exhaust pipes 40 and 44 are opened.

The metallic hollow-box-shaped deposition vessel 14 is grounded. The deposition vessel 14 is divided into an upper portion 14a and a lower portion 14b, and the upper portion 14a and the lower portion 14b are configured to be detachably attached to each other by a coupling mechanism (not illustrated). According to the configuration, the bell jar 34 can be taken out from the deposition vessel 14 to clean the dirt created by the plasma generation on an inner wall surface of the bell jar 34.

The antenna array (plasma source) 30 includes the plural antenna elements 28, the bell jar 34 and the substrate stage 32 in which a heater 50 is incorporated are sequentially provided from an upper wall side toward a lower wall side in the deposition vessel 14. The substrate 24 is placed on an upper surface of the substrate stage 32. The antenna array 30 is provided such that a virtual plane on which the antenna elements 28 are arrayed becomes parallel to the substrate placing surface of the substrate stage 32.

In order to generate the plasma using the oxidizing gas introduced to the second internal space 36, the antenna array 28 is provided so as to come close to a top of the bell jar. 34. The antenna array 28 is provided between a left wall of the deposition vessel 34 and a right wall in which the exhaust hole 46 is made, and the antenna array 28 is provided above an upper surface of the bell jar 34 while being parallel to the surface of the substrate stage 32. In the antenna array 28, the plural antenna elements 28 are disposed in parallel at constant intervals. The power is supplied to each of the plural antenna elements 28 such that the plasma is generated in the second internal space 36 when the oxidizing gas is supplied to the second internal space 36.

As illustrated in FIG. 2, a high-frequency signal (high-frequency power) having a VHF band (for example, 80 MHz) generated by the high-frequency signal generating section 14 is supplied to the distributor 15. The high-frequency signal is divided by the distributor 15, and the divided high-frequency signals are supplied to base portions, from which the plural antenna elements 28 are projected, through an impedance matching box 52. The impedance matching box 52 adjusts impedance mismatch generated by a change in load of each antenna element 28 during the generation of the plasma.

The antenna element 28 is configured such that a rod-shaped conductive monopole antenna (antenna body) 54 made of copper, aluminum, platinum or the like is accommodated in a cylindrical member 56 made of a dielectric material such as quartz and ceramic. A capacitance and an inductance are adjusted as the antenna by coating the antenna body with the dielectric material, and the high-frequency signal can efficiently be propagated along a longitudinal direction of the antenna body. Therefore, the antenna element 28 can efficiently radiate an electromagnetic wave to the surroundings.

Each of the antenna elements 28 extends in a direction orthogonal to a flow direction of the source gas flowing in the second internal space 36, and the antenna element 28 is attached in the electrically insulating manner so as to be projected from a sidewall of the deposition vessel 12. The antenna elements 28 are disposed in parallel at constant intervals, for example, intervals of 50 mm, and feed positions of two antenna elements adjacent to each other among the antenna elements 26 are located on opposite sidewalls each other.

Each of the antenna elements 28 is disposed in parallel with the substrate placing surface of the substrate stage 32. The direction in which the plural antenna elements 28 are arrayed is parallel to the substrate placing surface of the substrate stage 32.

For example, the antenna element 28 is configured such that the antenna body having a diameter of about 6 mm is provided in the dielectric cylindrical member having a diameter of about 12 mm. For the second internal space 36 whose pressure is about 20 Pa, when the high-frequency signal having the power of about 1600 W is supplied from the feed unit 12, a standing wave of the high-frequency signal is generated on a condition that the antenna length of the antenna element 28 is equal to (2n + 1)/4 (n is 0 or positive integer) times of a wavelength of the high-frequency signal, whereby the antenna element 28 becomes a resonant state. Therefore, the electromagnetic wave is radiated to the surroundings of the antenna elements 28 to generate the plasma.

The bell jar 34 is a box-shaped member made of quartz, and the bell jar 34 and the upper surface of the substrate stage 32 constitute the closed second internal space 36. The substrate 24 is disposed in the second internal space 36. The reason the bell jar 34 is provided in the first internal space 26 to form the second internal space 36 separated from the first internal space 26 in the first internal space 26 is that the plasma generation density can be enhanced by generating the plasma in the second internal space 36. Conventionally, the plasma generation density is low because a plasma generation area is a wide area including the plasma source such as the antenna element 28. In the embodiment, the plasma generation area is narrow because the plasma generation area is set according to the vacuum and is restricted within the second internal space 36. Therefore, the plasma generation density becomes higher than ever before, so that the thin film can efficiently be formed. Additionally, because members such as the antenna element 28 do not exist in the second internal space 36, the surface of the antenna element 28 and the like do not become dirty due to adhesion of the thin film. As described later, the bell jar 34 is detachable from the substrate stage 32, and the bell jar 34 can be taken out from the deposition vessel 14, so that the bell jar 34 whose surface becomes dirty can be cleaned. An etching solution is used as a cleaning solution, and the cleaning is performed by dipping the bell jar 34 in the cleaning solution. Therefore, the maintenance is easy to perform.

The substrate stage 32 has an area smaller than a section of the first internal space 26 surrounded by the inside walls of the deposition vessel 14. For example, the substrate stage 32 is a metallic rectangular plate. The substrate stage 32 is vertically elevated and lowered by a lifting mechanism 58 such as a power cylinder. The gas supply sections 16 and 18 and the exhaust section 21 are configured to be elevated and lowered in association with the elevation and lowering of the substrate stage 32. At one end portion of the substrate placing surface of the substrate stage 32, supply ports for the source gases supplied from the gas supply sections 16 and 18 are provided in the portion located in the second internal space 36. At the other end portion of the substrate placing surface of the substrate stage 32, an exhaust port connected to the exhaust section 21 is provided in the portion located in the second internal space 36. Therefore, the source gas flows from the supply ports toward the exhaust port above the substrate 24.

A heater stopper 60 projected toward the central portion from the inner wall surface of the deposition vessel 14 is provided between the inner wall surface and the elevation position of the substrate stage 32. An L-shape step is provided at a position corresponding to a level of a side face of the heater stopper 60 in an upper surface of an edge portion of the substrate stage 32.

When the substrate stage 32 is elevated, a lower surface of the heater stopper 60 abuts on the step portion on the upper surface of the edge portion of the substrate stage 32, and the upper surface of the substrate stage 32 is positioned so as to become substantially flush with the upper surface of the heater stopper 46. At this point, the first internal space 26 of the deposition vessel 14 is separated into a space above the substrate stage 32 and a space below the substrate stage 32.

On the other hand, when the substrate stage 32 is located at the lowering position, a gap 62 having a predetermined interval exists between the lower surface of the heater stopper 60 and the step portion on the upper surface of the edge portion of the substrate stage 32. The upper space and the lower space are connected through the gap 62, and the exhaust sections 20 and 22 evacuate the first internal space 26 to control the vacuum (pressure) at high speed in conjunction with each other. Because the bell jar 34 moves downward along with the substrate stage 32, a lower portion 14b of the deposition vessel 14 is separated from an upper portion 14a, which allows the bell jar 34 to be taken out from the lower portion 14b.

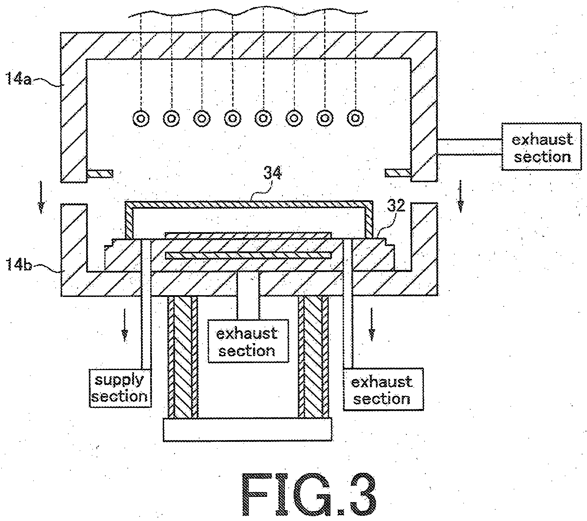

FIG. 3 illustrates the state in which, in the ALD apparatus 10, the substrate stage 32 is located at the lowering position while the lower portion 14b of the deposition vessel 14 is separated from the upper portion 14a to take out the bell jar 34. That is, the deposition vessel 14 can be separated into two regions of the upper portion 14a and the lower portion 14b such that the antenna element 28 is separated from the bell jar 34 and the substrate stage 32. The lower portion 14b of the deposition vessel 14 can move in the horizontal direction of FIG. 3 along with the substrate stage 32 to take out the bell jar 34 from the substrate stage 32.

In the ALD apparatus 10, in the state illustrated in FIG. 1, the vacuum of the first internal space 26 is controlled in the range of 1 × 10⁻³ to 1 × 10⁻² Pa or 1200 to 3000 Pa using the exhaust section 22. The vacuum of the second internal space 36 is controlled in the range of 20 to 100 Pa using the exhaust section 21, and the pressure is kept constant. That is, the pressure of the second internal space 36 and the pressure of the first internal space 26 are controlled so as to have a pressure difference.

Then, the source gas such as TMA is supplied from the gas supply section 16. At the same time, because the exhaust section 21 is driven, a source gas flows from the left to the right of FIG. 1 in the space (second internal space 36) above the substrate 24 placed on the upper surface of the substrate stage 32. Therefore, the source gas component is adsorbed on the substrate 24, and the excess source gas is exhausted. Then an inert gas is supplied to replace the gas in the second internal space 36.

Then the oxidizing gas flows onto the substrate 24 in the second internal space 36, and the high-frequency power is supplied to the antenna array 30 provided in the first internal space 26, thereby generating the plasma in the second internal space 36. At this point, the plasma is not generated in the first internal space 26, because the vacuum of the first internal space 26 is higher or lower than the vacuum of the second internal space 36. The plasma generation density is high because the plasma is generated only in the second internal space 36. Accordingly, an oxidation treatment of the component such as TMA adsorbed on the substrate 24 is performed for a short time using an oxygen radical produced by the plasma. Because the plasma is generated only in the second internal space 36, the excess substance does not adhere to the antenna element 28 and the like due to the plasma generation, and only the inner surface of the bell jar 34 becomes dirty. Because the bell jar 34 can be taken out, the bell jar 34 can easily be cleaned.

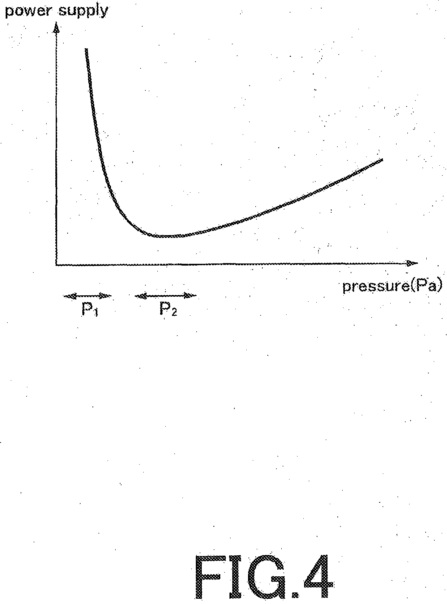

FIG. 4 is a graph illustrating a relationship between the vacuum (pressure) and the power (minimum power) supplied to the plasma source in generating the plasma. A characteristic curve of the graph is well known as a Paschen's law. Although the characteristic curves depend on types of the gasses, the shapes of the characteristic curves are similar to each other. In the embodiment, the pressure is controlled such that the pressure in the range of P₂ of FIG. 4 is set to the second internal space 36 while the pressure in the range of P₁ of FIG. 4 is set to the first internal space 26.

The power, which is higher than the supply power defined by the range of P₂ of FIG. 4 and lower than the supply power defined by the range of P₁ of FIG. 4, is supplied to each antenna element 28 of the antenna array 30, which allows the plasma to be generated in the second internal space 36 without generating the plasma in the first internal space 26. That is, the high-frequency power supplied to the antenna array 30 is lower than the minimum power with which the plasma is generated at the pressure of the first internal space 26 and higher than the minimum power with which the plasma is generated at the pressure of the second internal space 36. Obviously, in the first internal space 26, the pressure may be controlled so as to be set higher than that in the range of P₂ of FIG. 4.

In the embodiment, the antenna array 30 is used as the plasma source. Alternatively, various types of the plasma sources such as CCP (Capacitively-Coupled Plasma), ICP (Inductively-Coupled Plasma), and ECR (Electron-Cyclotron Resonance Plasma) can be applied. In a case of a use of the inductively-coupled plasma source as well as the electromagnetically-coupled plasma source in which the antenna such as the antenna array 30, preferably the bell jar 34 is made of quartz.

As described above, in the embodiment, the pressure is controlled such that the plasma is generated in not the first internal space where the plasma source is located but the second internal space provided in the first internal space. Therefore, the generation density of the plasma generated in the second internal space can be enhanced to efficiently form the thin film.

Additionally, because the inside vacuum vessel constituting the second internal space is configured to be detachably attached to the substrate stage, the inside vacuum vessel can easily be cleaned to ensure the ease of maintenance.

The thin film forming apparatus and the thin film forming method according to the embodiment of the invention are described in detail. However, the invention is not limited to the thin film forming apparatus and the thin film forming method of the embodiment. Obviously various changes and modifications can be made without departing from the scope of the invention as defined by the appended claims.

### DESCRIPTION OF LETTERS OR NUMERALS

- 10: ALD apparatus
- 12: feed unit
- 13: high-frequency signal generator
- 14: deposition vessel
- 14a: upper portion
- 14b: lower portion
- 15: distributor
- 16, 18: gas supply section
- 20, 21, 22: exhaust section
- 24: substrate
- 26: first internal space
- 28: antenna element
- 30: array antenna, plasma source
- 32: substrate stage
- 34: bell jar
- 36: second internal space
- 38, 40: supply pipe
- 41, 44, 48: exhaust pipe
- 42, 46: exhaust hole
- 50: heater
- 52: impedance matching box
- 54: monopole antenna
- 56: cylindrical member
- 58: lifting mechanism
- 60: heater stopper
- 62: gap

## Claims

1. A thin film forming apparatus (10) for forming a thin film on a substrate (24) using plasma, comprising:
an outside vacuum vessel (14) constituting a first internal space (26);
a bell jar (34) provided in the first internal space of the outside vacuum vessel to constitute a second internal space (36);
a plasma source (30) provided in the first internal space (26), the plasma source (30) receiving supply of a high-frequency power to generate the plasma; and
a substrate stage (32) provided opposite to the plasma source in the first internal space (26) and configured in such a way that the substrate (24) can be placed thereon in the second internal space (36),
a first vacuum pump connected to the first internal space (26), and
a second vacuum pump connected to the second internal space (36), a plasma source (30) including plural antenna elements (28) and provided in the first internal space (26),
a feed unit (12) configured to supply a power to each antenna element (28) of the plasma source (30),
the feed unit (12) including a high-frequency signal generator (13) and a distributor (15), and
the high-frequency signal generator (13) including an oscillator and an amplifier,
wherein
the second internal space (36) is surrounded by the substrate stage (32) and the bell jar (34),
the first vacuum pump and the second vacuum pump are configured to control pressures of the first internal space (26) and the second internal space (36) and the feed unit (12) is configured to control the power supplied to the plasma source such that the plasma is generated in the second internal space (36) while not generated in the first internal space (26),
the first vacuum pump and the second vacuum pump are configured to control the pressure of the second internal space (36) and the pressure of the first internal space (26) so as to have a pressure difference,
the first vacuum pump and the second vacuum pump are configured to control the pressures of the first internal space (26) and the second internal space (36) such that the pressure of the first internal space becomes 1 × 10⁻³ to 1 × 10⁻² Pa or 1200 to 3000 Pa and such that the pressure of the second internal space becomes 20 to 100 Pa,
a antenna element (28) constituting the plasma source (30), the bell jar (34), and the substrate stage (32) are sequentially disposed from above in the outside vacuum vessel (14), and
the outside vacuum vessel (14) is separated into two regions (14a, 14b) such that the antenna element (28) is separated from the bell jar (34) and the substrate stage (32).

2. The thin film forming apparatus (10) according to claim 1, wherein the feed unit (12) is configured to control the power supplied to the plasma source (30) so as to be lower than a minimum power with which the plasma is generated at the pressure of the first internal space (26) and higher than a minimum power with which the plasma is generated at the pressure of the second internal space (36).

3. The thin film forming apparatus (10) according to any one of claims 1 to 2, wherein the plasma source (30) is an electromagnetically-coupled source or an inductively-coupled source, and the bell jar (34) is made of quartz.

4. The thin film forming apparatus (10) according to any one of claims 1 to 3, wherein a supply port and an exhaust port of a source gas are provided on a surface of the substrate stage located in the second internal space.

5. The thin film forming apparatus (10) according to any one of claims 1 to 4, wherein the bell jar (34) is configured to be detachably placed on the substrate stage (32).

6. A thin film forming method for forming a thin film on a substrate (24) using plasma, comprising the steps of:
controlling pressures of a first internal space (26) and a second internal space (36) provided in the first internal space (26) according to determined pressure conditions, the first internal space (26) being constituted by an outside vacuum vessel (14), the second internal space (36) being constituted by a bell jar (34);
causing a source gas to flow onto the substrate (24) in the second internal space (36) and supplying a high-frequency power to a plasma source (30) provided in the first internal space (26) according to the pressure conditions, thereby generating the plasma in the second internal space (36) to form the thin film on the substrate (24),
controlling the pressure conditions such that the pressure of the second internal space (36) and the pressure of the first internal space (26) have a pressure difference, and
controlling the pressure of the first internal space (26) in a range of 1 × 10⁻³ to 1 × 10⁻² Pa or 1200 to 3000 Pa and the pressure of the second internal space (36) in a range of 20 to 100 Pa,
separating the outside vacuum vessel (14) into two regions of an upper portion (14a) and a lower portion (14b) such that the antenna element (28) is separated from the bell jar (34) and the substrate stage (32),
wherein
an antenna elements (28) constituting the plasma source (30), the bell jar (34), and the substrate stage (32) are sequentially disposed from above in the outside vacuum vessel (14), and
the outside vacuum vessel (14) is separated into two regions such that the antenna element (28) is separated from the bell jar (34) and the substrate stage (32).

7. The thin film forming method according to claim 6, wherein the high-frequency power supplied to the plasma source is lower than a minimum power with which the plasma is generated at the pressure of the first internal space (26) and higher than a minimum power with which the plasma is generated at the pressure of the second internal space (36).

## Patentansprüche

1. Dünnschichtbildungsvorrichtung (10) zum Bilden einer Dünnschicht auf einem Substrat (24) mittels Plasma, die aufweist:
ein äußeres Vakuumgefäß (14), das einen ersten Innenraum (26) bildet;
eine Vakuumglocke (34), die im ersten Innenraum des äußeren Vakuumgefäßes vorgesehen ist, um einen zweiten Innenraum (36) zu bilden;
eine Plasmaquelle (30), die im ersten Innenraum (26) vorgesehen ist, wobei die Plasmaquelle (30) eine Zufuhr einer Hochfrequenzleistung empfängt, um das Plasma zu erzeugen; und
einen Substrattisch (32), der gegenüber der Plasmaquelle im ersten Innenraum (26) vorgesehen ist und in einer solchen Weise konfiguriert ist, dass das Substrat (24) darauf im zweiten Innenraum (36) angeordnet werden kann,
eine erste Vakuumpumpe, die mit dem ersten Innenraum (26) verbunden ist, und
eine zweite Vakuumpumpe, die mit dem zweiten Innenraum (36) verbunden ist,
eine Plasmaquelle (30), die mehrere Antennenelemente (28) aufweist und im ersten Innenraum (26) vorgesehen ist,
eine Einspeiseeinheit (12), die konfiguriert ist, jedem Antennenelement (28) der Plasmaquelle (30) Leistung zuzuführen,
wobei die Einspeiseeinheit (12) einen
Hochfrequenzsignalgenerator (13) und einen Verteiler (15) aufweist, und
wobei der Hochfrequenzsignalgenerator (13) einen Oszillator und einen Verstärker aufweist,
wobei
der zweite Innenraum (36) durch den Substrattisch (32) und
die Vakuumglocke (34) umgeben ist,
die erste Vakuumpumpe und die zweite Vakuumpumpe konfiguriert sind, Drucke des ersten Innenraums (26) und
des zweiten Innenraums (36) zu regeln, und die Einspeiseeinheit (12) konfiguriert ist, die der Plasmaquelle zugeführte Leistung so zu regeln, dass das Plasma im zweiten Innenraum (36) erzeugt wird, während es im ersten Innenraum (26) nicht erzeugt wird,
die erste Vakuumpumpe und die zweite Vakuumpumpe konfiguriert sind, den Druck des zweiten Innenraums (36) und den Druck des ersten Innenraums (26) so zu regeln, dass eine Druckdifferenz erhalten wird,
die erste Vakuumpumpe und die zweite Vakuumpumpe konfiguriert sind, die Drucke des ersten Innenraums (26) und des zweiten Innenraums (36) so zu regeln, dass der Druck des ersten Innenraums 1 x 10⁻³ bis 1 x 10⁻² Pa oder 1200 bis 3000 Pa annimmt und so dass der Druck des zweiten Innenraums 20 bis 100 Pa annimmt,
ein Antennenelement (28), das die Plasmaquelle (30) bildet,
die Vakuumglocke (34), und der Substrattisch (32) aufeinanderfolgend von oben im äußeres Vakuumgefäß (14) angeordnet werden, und
das äußere Vakuumgefäß (14) in zwei Bereiche (14a, 14b) unterteilt ist, so dass das Antennenelement (28) von der Vakuumglocke (34) und dem Substrattisch (32) getrennt ist.

2. Dünnschichtbildungsvorrichtung (10) nach Anspruch 1, wobei die Einspeiseeinheit (12) konfiguriert ist, die der Plasmaquelle (30) zugeführte Leistung so zu regeln, dass sie niedriger als eine minimale Leistung, mit der das Plasma unter dem Druck des ersten Innenraums (26) erzeugt wird, und höher als eine minimale Leistung ist, mit der Plasma unter dem Druck des zweiten Innenraums (36) erzeugt wird.

3. Dünnschichtbildungsvorrichtung (10) nach einem der Ansprüche 1 bis 2, wobei die Plasmaquelle (30) eine elektromagnetisch gekoppelte Quelle oder eine induktiv gekoppelte Quelle ist, und die Vakuumglocke (34) aus Quarz besteht.

4. Dünnschichtbildungsvorrichtung (10) nach einem der Ansprüche 1 bis 3, wobei ein Zufuhranschluss und ein Ablassanschluss eines Quellgases an einer Oberfläche des Substrattisches vorgesehen sind, der im zweiten Innenraum angeordnet ist.

5. Dünnschichtbildungsvorrichtung (10) nach einem der Ansprüche 1 bis 4, wobei die Vakuumglocke (34) konfiguriert ist, abnehmbar am Substrattisch (32) angeordnet zu werden.

6. Dünnschichtbildungsverfahren zum Bilden einer Dünnschicht auf einem Substrat (24) mittels Plasma, das die Schritte aufweist:
Regeln von Drucken eines ersten Innenraums (26) und eines zweiten Innenraums (36), der im ersten Innenraum (26) vorgesehen ist, gemäß festgelegten Druckbedingungen, wobei der erste Innenraum (26) durch ein äußeres Vakuumgefäß (14) gebildet wird und der zweite Innenraum (36) durch eine Vakuumglocke (34) gebildet wird;
Bewirken, dass ein Quellgas auf das Substrat (24) im zweiten Innenraum (36) strömt und Zuführen einer Hochfrequenzleistung zu einer Plasmaquelle (30), die im ersten Innenraum (26) vorgesehen ist, gemäß den Druckbedingungen, wodurch das Plasma im zweiten Innenraum (36) erzeugt wird, um die Dünnschicht auf dem Substrat (24) zu bilden,
Regeln der Druckbedingungen, so dass der Druck des zweiten Innenraums (36) und der Druck des ersten Innenraums (26) eine Druckdifferenz aufweisen, und
Regeln des Drucks des ersten Innenraums (26) in einem Bereich von 1 x 10⁻³ bis 1 x 10⁻² Pa oder 1200 bis 3000 Pa und des Drucks des zweiten Innenraums (36) in einem Bereich von 20 bis 100 Pa,
Aufteilen des äußeren Vakuumgefäßes (14) in zwei Bereiche eines oberen Abschnitts (14a) und eines unteren Abschnitts (14b), so dass das Antennenelement (28) von der Vakuumglocke (34) und dem Substrattisch (32) getrennt ist, wobei
ein Antennenelement (28), das die Plasmaquelle (30) bildet, die Vakuumglocke (34), und der Substrattisch (32) aufeinanderfolgend von oben im äußeres Vakuumgefäß (14) angeordnet werden, und
das äußere Vakuumgefäß (14) in zwei Bereich unterteilt ist, so dass das Antennenelement (28) von der Vakuumglocke (34) und dem Substrattisch (32) getrennt ist.

7. Dünnschichtbildungsverfahren nach Anspruch 6, wobei die der Plasmaquelle zugeführte Hochfrequenzleistung niedriger als eine minimale Leistung, mit der das Plasma unter dem Druck des ersten Innenraums (26) erzeugt wird, und höher als eine minimale Leistung ist, mit der das Plasma unter dem Druck des zweiten Innenraums (36) erzeugt wird.

## Revendications

1. Appareil de formation de couche mince (10) destiné à former une couche mince sur un substrat (24) au moyen de plasma, comprenant:
un récipient extérieur sous vide (14) formant un premier espace intérieur (26) ;
une cloche de verre (34) prévue dans le premier espace intérieur du récipient extérieur sous vide pour former un deuxième espace intérieur (36) ;
une source de plasma (30) prévue dans le premier espace intérieur (26), ladite source de plasma (30) étant alimentée par un courant haute fréquence pour générer le plasma ; et
un degré (32) de substrat opposé à la source de plasma dans le premier espace intérieur (26) et prévu de sorte que le substrat (24) peut être disposé sur celui-ci dans le deuxième espace intérieur (36),
une première pompe à vide reliée au premier espace intérieur (26), et
une deuxième pompe à vide reliée au deuxième espace intérieur (36),
une source de plasma (30) comprenant plusieurs éléments d'antenne (28) et prévue dans le premier espace intérieur (26),
une unité d'alimentation (12) prévue pour alimenter chaque élément d'antenne (28) de la source de plasma (30) en courant,
l'unité d'alimentation (12) comprenant un générateur de signaux haute fréquence (13) et un distributeur (15), et
le générateur de signaux haute fréquence (13) comprenant un oscillateur et un amplificateur,
où
le deuxième espace intérieur (36) est entouré par le degré (32) de substrat et la cloche de verre (34),
la première pompe à vide et la deuxième pompe à vide sont prévues pour commander des pressions du premier espace intérieur (26) et du deuxième espace intérieur (36), et
l'unité d'alimentation (12) est prévue pour commander le courant alimentant la source de plasma de manière à générer le plasma dans le deuxième espace intérieur (36) quand il n'est pas généré dans le premier espace intérieur (26),
la première pompe à vide et la deuxième pompe à vide sont prévues pour commander la pression du deuxième espace intérieur (36) et la pression du premier espace intérieur (26) de manière à obtenir un différentiel de pression,
la première pompe à vide et la deuxième pompe à vide sont prévues pour commander les pressions du premier espace intérieur (26) et du deuxième espace intérieur (36) de sorte que la pression du premier espace intérieur soit comprise entre 1 x 10⁻³ et 1 x 10⁻² Pa ou entre 1200 et 3000 Pa et que la pression du deuxième espace intérieur soit comprise entre 20 et 100 Pa,
un élément d'antenne (28) formant la source de plasma (30),
la cloche de verre (34) et le degré (32) de substrat étant séquentiellement disposés depuis le haut dans le récipient extérieur sous vide (14), et où
le récipient extérieur sous vide (14) est séparé en deux zones (14a, 14b) de manière à séparer l'élément d'antenne (28) de la cloche de verre (34) et du degré (32) de substrat.

2. Appareil de formation de couche mince (10) selon la revendication 1, où l'unité d'alimentation (12) est prévue pour commander le courant alimentant la source de plasma (30) de manière à le rendre inférieur à un courant minimal avec lequel le plasma est généré sous la pression du premier espace intérieur (26) et à le rendre supérieur à un courant minimal avec lequel le plasma est généré sous la pression du deuxième espace intérieur (36).

3. Appareil de formation de couche mince (10) selon la revendication 1 ou la revendication 2, où la source de plasma (30) est une source à couplage électromagnétique ou une source à couplage inductif, et où la cloche de verre (34) est en quartz.

4. Appareil de formation de couche mince (10) selon l'une des revendications 1 à 3, où un orifice d'alimentation et un orifice d'évacuation d'un gaz source sont prévus sur une surface du degré de substrat disposé dans le deuxième espace intérieur.

5. Appareil de formation de couche mince (10) selon l'une des revendications 1 à 4, où la cloche de verre (34) est prévue pour être disposée de manière amovible sur le degré (32) de substrat.

6. Procédé de formation d'une couche mince, pour la formation d'une couche mince sur un substrat (24) au moyen de plasma, comprenant les étapes suivantes:
commande des pressions d'un premier espace intérieur (26) et d'un deuxième espace intérieur (36) prévu dans le premier espace intérieur (26) conformément à des conditions de pression définies, le premier espace intérieur (26) étant formé par un récipient extérieur sous vide (14), le deuxième espace intérieur (36) étant formé par une cloche de verre (34) ;
déclenchement d'un flux d'un gaz source sur le substrat (24) dans le deuxième espace intérieur (36) et alimentation en courant haute fréquence d'une source de plasma (30) prévue dans le premier espace intérieur (26) conformément aux conditions de pression pour générer le plasma dans le deuxième espace intérieur (36) afin de former la couche mince sur le substrat (24),
commande des conditions de pression de sorte que la pression du deuxième espace intérieur (36) et la pression du premier espace intérieur (26) présentent un différentiel de pression, et
commande de la pression du premier espace intérieur (26) dans une plage de 1 x 10⁻³ à 1 x 10⁻² Pa ou de 1200 à 3000 Pa et de la pression du deuxième espace intérieur (36) dans une plage de 20 à 100 Pa,
division du récipient extérieur sous vide (14) en deux zones d'une partie supérieure (14a) et d'une partie inférieure (14b), de manière à séparer l'élément d'antenne (28) de la cloche de verre (34) et du degré (32) de substrat,
où
un élément d'antenne (28) formant la source de plasma (30),
la cloche de verre (34) et le degré (32) de substrat sont séquentiellement disposés depuis le haut dans le récipient extérieur sous vide (14), et où
le récipient extérieur sous vide (14) est séparé en deux zones de manière à séparer l'élément d'antenne (28) de la cloche de verre (34) et du degré (32) de substrat.

7. Procédé de formation d'une couche mince selon la revendication 6, où le courant haute fréquence alimentant la source de plasma est inférieur à un courant minimal avec lequel le plasma est généré sous la pression du premier espace intérieur (26) et supérieur à un courant minimal avec lequel le plasma est généré sous la pression du deuxième espace intérieur (36).
